# EUROPEAN PATENT APPLICATION

(11) **EP 2 315 240 A1**
(43) Date of publication of application: **27.04.2011**
(21) Application number: 09804793.9
(22) Date of filing: 01.05.2009
(51) Int. Cl.: H01L 21/60

(54) **ALUMINUM RIBBON FOR ULTRASONIC BONDING**

(30) Priority: 05.08.2008 JP 2008201994
(71) Applicant: Tanaka Denshi Kogyo K.K., Tokyo 100-6422 (JP)
(72) Inventor: MIKAMI Michitaka, Kanzaki-gun Saga 842-0031 (JP); KIKUCHI Teruo, Kanzaki-gun Saga 842-0031 (JP); HIRATA Yuichi, Kanzaki-gun Saga 842-0031 (JP); NAKASHIMA Shinichiro, Kanzaki-gun Saga 842-0031 (JP); SATOU Matsumi, Kanzaki-gun Saga 842-0031 (JP); KIMURA Keisuke, Kanzaki-gun Saga 842-0031 (JP)
(74) Representative: Hössle Patentanwälte Partnerschaft
(86) International application number: PCT/JP2009/058545
(87) International publication number: WO 2010/016306

(57) **Abstract**

To provide a bonding ribbon which can be realized the stable bonding strength, which has a homogeneous whole bonded surface every time for several ten thousands bonding cycles.

An aluminum ribbon for ultrasonic bonding comprising: an aluminum alloy is more than 99 wt % of Al, it contains additive elements and residual aluminum, wherein it has ultra thin tape structure roll rolled after multi stages drawing, wherein the average crystal grain size at a cross section of the ribbon is 5 - 200 µm, wherein it is featured the ratio of the thickness to the width is 1/2 - 1/20.

It is preferable that the aspect ratio of crystal grain (width direction/thickness direction) is 0.5 - 10 and the surface of the tape is mirror-finished wherein the surface roughness R_{z} is less than 2 µm and/or equals to 2 µm.

## Description

This application is based on International Application No. PCT/JP2009/58545, filed on May 1, 2009 (which has the following Priority Data: Japanese Patent Application No. 2008-201994, filed on August 5, 2008), the entire contents of which are incorporated herein by reference.

### FIELD OF THE INVENTION

The present invention relates to an aluminum ribbon connecting by ultrasonic bonding with semiconductor devices and lead parts of substrates in electric parts and semiconductor packages.

### STATE OF THE ART

In semiconductor device manufacturing, the method of bonding using electric conductor which is a tape shape of rectangular cross-section (termed "ribbon" hereinafter.) in order to connect electrically with connecting electrodes on semiconductor chips and outer lead terminals on semiconductor packages (leads) is widely used.
This method is an application of ultrasonic wire bonding method using aluminum conductive wire, and it is applying load and ultrasonic vibration onto an aluminum ribbon, and breaking the 1 nm thickness oxide membrane formed on the aluminum ribbon naturally, in order to expose aluminum metallic atoms on the surface, increasing the new surface contacting tightly each other, generating plastic flow at the boundary with aluminum and/or nickel pads and an aluminum ribbon, and bonded with atomic bond.

This practical aluminum ribbon has been produced by the following manufacturing methods of conventional ultra thin tape so far.
The first method is cutting a sheet-metal of the aluminum alloy rolled like a thin plate in advance at a prescribed width and length by a press machine or a rotary cutter for instance, and forming a final prescribed shape of aluminum ribbon.
The second method is forming a final prescribed shape of aluminum ribbon from slitting or pressing of both edges of tape shape material which is rolled into a final ultra thin tape aluminum alloy rolled (where the ratio of width to thickness is around 25).

However, in the above mentioned metal working method of ultra thin tape, as machine oil is generally used at rolling, an oil membrane of less than the limit of detection remains and is distributed heterogeneously on the surface of the aluminum ribbon, so it is the cause of unstable condition of bonding, when using aluminum ribbon for ultrasonic bonding. Therefore, acid-cleaning of the surface of the bonding ribbon by chemical etching has been tried, but microscopic bumps on the bonding ribbon surface are generated by chemical etching, and the bonding condition becomes unstable at ultrasonic bonding using this bumpy surface.

Moreover, an aluminum ribbon which consists of purity of more than 99 wt % of aluminum and additives is softer than a conventional aluminum plate which has purity of 99.99 wt % for ultrasonic bonding, horns or burrs are apt to generate at a cutting cross-section or a shearing cross-section, and these remain at the edge of the ribbon, and these are caught at guides and tools at bonding, and these become flaky shape, and these adhere to the surface of the rolling roll, then the surface of ribbon becomes bumpy. Therefore, an aluminum ribbon used to bond keeping the hardness of rolling for ultrasonic bonding, and as it requires large energy at bonding, so it has such issues of unstable bonding condition and lesser strength of bonding.

For the bonding condition becoming unstable as above mentioned, the following reasons had been considered so far. Namely, the surfaces of bonding pads and bonding ribbons are not flat at microscopic level, membrane of aluminum oxide of around 1 nm thickness is not homogeneous, and position and size of contact parts of bonding ribbons and bonding pads do not become constant at very initial stage.
Therefore, various shapes of bonding ribbons have been tried in order to achieve stable strength of bonding (bonding strength), and establish stable bonding conditions of bonding ribbons (Reference Patent 1 and Reference Patent 2).

For instance, in the Reference Patent 1, "Material for electric current path formed as a shape of almost plate in external appearance" is disclosed. And "the shape of connection strap does not mind any shape like shape of plate or shape of ribbon above mentioned, but rectangular in cross section. For example, it is available such as ellipse shape, depressed ellipse shape (oval shape, old Japanese gold coin shape), trapezoid shape. Moreover, it is available to apply these shapes, and it may be used proper combination." is described. However, the connection strap described in the Reference Patent 1 has a plane surface of connection; instability issue of bonding condition is not resolved specifically as bonding strength is unstable because position and size in microscopic contact at initial stage of bonding are not uniform.

On the other hand, in the Reference Patent 2, bonding ribbon, which has tips of plural protuberances in the same tangent plane featured one side to be bonded in external appearance, is disclosed. It is considered that it becomes possible to break oxide membrane easily formed at surface by plural protuberances generating friction between a ribbon and a connected object. In this method, it is considered that generating plastic flow in early moment is easy, getting stable bonding strength by relatively lesser load and ultrasonic energy is realized, comparing against a flat ribbon.

However, in the case of aluminum ribbon to connect with semiconductor devices by ultrasonic bonding, a constant condition of automatic ultrasonic bonding is required at the speed ratio of one piece and/or several pieces for a second for several ten thousands cycles. As the manner disclosed in the Reference Patent 2, even though tips of plural protuberances are formed, as soon as plastic flow starts to break oxide membrane in microscopic aspects, the whole balance of bonding condition is loosed, it becomes impossible to bond under constant condition for several ten thousands cycles. Thus, in the conventional method, such as changing the external appearance of bonding ribbon, it is difficult to bond under constant condition for several ten thousands cycles, and it has been very hard to obtain high and stable bonding strength.

### THE PRECEDING TECHNICAL LITERATURE

### [Reference Patents]

[Reference Patent 1] JPA 2002-313851
[Reference Patent 2] JPA 2007-194270

### DISCLOSURE OF INVENTION

### ISSUES TO BE SOLVED BY THE PRESENT INVENTION

The present invention aims to provide a bonding ribbon, which is able to realize more stable bonding strength and more homogeneous bonding every time for the whole bonding area, and superior than the conventional technique, during several ten thousands of bonding cycles, in the ultrasonic bonding using a bonding ribbon.

### ISSUES TO BE SOLVED BY THE PRESENT INVENTION

As the means to be solve the above mentioned issues, the ultrasonic bonding aluminum ribbon of the present invention has the following features:
An aluminum ribbon for ultrasonic bonding consists of aluminum alloy with purity of more than 99 wt % of Al with additive elements and residual aluminum. It has ultra thin tape structure formed by multi-stage cold rolling mills. The average crystal grain size of the cross section of this ribbon is 5 - 200 µm. And the surface of this ultra thin tape is mirror-finished, which surface roughness of R_{z} is less than and/or equals 2 µm.

It is preferable that the total amount of additive elements, comprising at least one element selected from Ni, Si, Mg and Cu, is 5 - 700 wt ppm.

It is specifically preferable that the additive element is 10 - 300 wt ppm of Ni.

Moreover, it is preferable that the residual aluminum has a purity of more than 99.99 wt % of Al and its impurity is less than 0.01 wt %, and moreover, it is more preferable that the residual aluminum has a purity of more than 99.999 wt % of Al and its impurity is less than 0.001 wt %.

### EFFECTS OF THE PRESENT INVENTION

It becomes possible to realize stable bonding strength as same as a bonding wire for a bonding ribbon using the above mentioned means. Especially aligning the crystal grain size, dispersion of bonding strength which has been a problem so far becomes small, and stable bonding strength is acquired even in low ultrasonic power, and bonding defects by outbreak unknown cause disappear completely. Moreover, using the bonding ribbon of the present invention, generation of micro voids at bonding boundary can be avoidable and securing stable bonding area, and stable ultrasonic bonding is acquired even in the case of narrow pitch pads.

By the way, even the new active surface may appear as the first stage of rolling on an aluminum ribbon except surface formed by multi-stages drawing, aluminum of the active surface will be oxidized immediately by the oxygen in the Air, and an oxidized aluminum membrane with thickness of around 1 nanometer. As this oxidized aluminum membrane would not be bonded each other, so a form of multi-layers-wind of aluminum ribbon becomes possible. If the bonding strength of this form of multi-layers-wind of aluminum ribbon is stable, the unmanned continuous ultrasonic bonding process becomes possible.

### BRIEF DESCRIPTION OF THE DRAWINGS

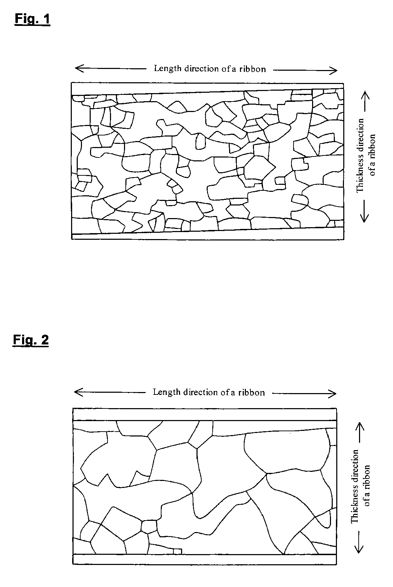

[Fig. 1] A photograph (traced) of Example 1, which has the average of 13 µm of crystal grain size of aluminum for ultrasonic bonding of the present invention.
[Fig. 2] A photograph (traced) of Example 4, which has the average of 40 µm of crystal grain size of aluminum for ultrasonic bonding of the present invention.

### DESCRIPTION OF THE MOST PREFERRED EMBODIMENT

The inventors of the present invention have invented paying attention to the effect of crystal system of an aluminum ribbon to the mechanism of bonding at ultrasonic bonding. As the internal crystal structure of an ultra thin tape after multi-stages cold rolling has a fiber structure, and its crystal grain size is less than 1 µ meter, it is impossible to observe such crystal grain size of an aluminum ribbon by a conventional optical microscope. Even if low temperature heat treatment for releasing strain is applied to this ultra thin tape, consequently the fiber structure would not change. When bonding an aluminum ribbon of such crystal structure by ultrasonic micro vibration to bonding pads, as the internal structure of aluminum ribbon is hard as rolled, large energy at bonding rather required, and on the other hand the bonding strength is low. It is considered that transferring speed of ultrasonic wave in the fiber structure is high, but deformation at bonding boundary does not promote because of too hard material.

However, it is become possible to condition the hardness, which deform sufficiently at bonding boundary of an aluminum ribbon by bonding energy after adequate temperature heat treatment of this multi-stages cold rolled ultra thin tape. Moreover, homogenizing crystal grain, disappearing microscopic defaults such as internal strains, transferring of ultrasonic wave and the load become homogeneous, then effect of decreasing dispersion of bonding strength (where, dispersion of bonding strength means decline of bonding strength after reliability test ( HAST) ) is generated.
This time, the inventors of the present invention discovered the domain of optimal crystal grain size and control method of crystal structure of an aluminum ribbon, and confirmed its re-manufacturability. This crystal structure has good balance between deformation at bonding boundary by the load contributing bonding strength and removal of oxidized membrane at bonding boundary by the ultrasonic wave.

Heat treatment condition which the crystal grain size becomes homogenous can not be defined as a definite condition depending on material and shape of aluminum ribbon. In the case of general aluminum ribbon which consists of additive elements and residual is more than 99 wt % of Al, when the thickness of ribbon is 1 mm, the condition of 250 - 400 degrees Celsius for 30 - 90 min may become a rough guideline for precipitation of adequate crystal grain size of the present invention. When the thickness of ribbon is less than 1 mm, it is apt to be lower heat treatment temperature and shorter heat treatment time, in the case of thickness is less than 10 µm, general heat treatment condition is 200 - 250 degrees Celsius for 10 - 60 min. By the way, the atmosphere of heat treatment is enough in the Air.
In the case of heat treatment temperature is less than 180 degrees Celsius, even if consuming longer time, an aluminum ribbon which is aluminum alloy of purity more than 99 wt % of Al remains state of fiber structure, it is not preferable because the average of crystal grain size do not grow more than 5 µm in the cross section of aluminum ribbon. At this condition, hardness of ribbon itself is high and plastic deformation at bonding boundary is inefficient. Moreover, under this heat treatment condition remaining the average of less than 5 µm, as un-recrystalization part remains, deformation between recrystallization part and un-recrystallization part varies at bonding boundary of ribbon at ultrasonic bonding, and this becomes cause of greater dispersion of bonding strength.

In the case of exceeding 450 degrees Celsius of heat treatment, the crystal grain size of aluminum alloy with purity of more than 99 wt % of Al become coarse and homogenization of crystal structure is difficult. In this case, the average crystal grain size is exceeding 200 µm for a1 mm thickness ribbon, the aluminum ribbon itself becomes easily deformable, and transmission of ultrasonic wave in the material becomes difficult, it is not preferable because the balance between transmission of ultrasonic wave and deformation by the load becomes bad.
In general, the thickness of aluminum ribbon is preferable at the range of between 10 µm and 1 mm from the aspect of the optimal balance between ultrasonic wave and load.

As the average crystal grain size of an aluminum ribbon is within the range of 5 - 200 µm, good bonding strength is acquired with this crystal grain size of aspect ratio (width direction/thickness direction) is the range of 0.5 - 10 in the present invention. And stable bonding strength is able to acquire when cutting an aluminum ribbon after the secondary ultrasonic bonding. Measurement method of the aspect ratio is measured width direction / thickness direction of crystal grain along length direction of ribbon.

The preferable range of ratio between width and thickness of aluminum ribbon is within 7 - 16. The representative width and thickness of aluminum ribbon is shown in following Table 1.

**Table 1 Aspect ratio of an aluminum ribbon (Width / Thickness)**

| | Aluminum ribbon | | |
|---|---|---|---|
| | Thickness (mm) | Width (mm) | Aspect ratio |
| 1 | 0.7 - 1.0 | 0.07 - 0.1 | 7 - 10 |
| 2 | 2.0 - 2.2 | 0.2 - 0.22 | 9 - 11 |
| 3 | 2.8 - 3.0 | 0.2 - 0.3 | 10 - 14 |
| 4 | 3.3 - 3.5 | 0.33 - 0.35 | 8 - 12 |

On the other hand, it is known that at the surface of an aluminum ribbon, Al is oxidized to form an oxidized membrane having a thickness of about 1 nanometer. So far, it has been thought that this oxidized membrane has no relationship with bonding strength because of its thinness. But if there are microscopic bumps on the surface of aluminum ribbon, the surface area increases, the amount of oxide also increases more. As aluminum oxide does not contribute to bonding, varying the amount of oxide at the bonding boundary may be a cause of dispersion of bonding strength at ultrasonic bonding. Therefore, in the case of an ultrasonic bonded aluminum ribbon in the same appearance, the phenomena used to observe conventionally what HAST strength is not stable. It is considered that they would intend to have a stable bonding strength by increasing ultrasonic power so far.

The inventors of the present invention discovered that it is possible to get stabilized bonding strength by low power of ultrasonic wave, when mirror-finished aluminum ribbon is used in order to decrease amount of oxide of bumpy surface at bonding boundary, within the range of 5 - 200 µm of the crystal grain size of aluminum ribbon.
It is preferable that the more mirror-finished aluminum ribbon is the more decreasing oxidized surface area. The roughness criterion R_{z} is less than 2 µm or equals 2 µm.
Since the 10 - 120 Hz high frequency is used at ultrasonic bonding of aluminum ribbon, it is possible to realize stable bonding strength within the range of 5 - 200 µm of the average crystal grain size of aluminum ribbon and the surface roughness is less than 2 µm or equals 2 µm for a aluminum alloy of 99 wt % of Al. Since it is soft, it can avoid micro voids. More preferably, R_{z} is less than 1.6 µm or equal to 1.6 µm.

The composition of an aluminum ribbon of the present invention is an aluminum alloy of the whole purity of more than 99 wt % of Al, and consists of additive elements and residual aluminum. Available additive elements are listed such as Ni, Si, Mg, Cu, B, In, Li, Be, Ca, Sr, Y, La, Ce, Nd, and Bi. The more effective elements to the crystal grain size of aluminum ribbon are Ni, Si, Mg and Cu. In the case of an aluminum alloy of the purity of 99 wt % of Al, containing total 5 - 700 wt ppm of at least one element among these available additives, crystal grain size is possible to grow homogeneously at 200 - 400 degrees Celsius.
There are inevitable impurities in the residual aluminum of a purity of more than 99 % aluminum alloy. However, as the effect to aluminum element by these inevitable impurity is not well known, so the lesser inevitable impurity is more preferable. In order to materialize stable condition of homogeneous crystal grain growth of aluminum ribbon, the purity of 99.99 wt % of Al as mother aluminum alloy is preferable. As the purity of 99.99 wt % of Al, the average of 5 - 200 µm crystal grain size is homogeneously grown at 200 - 400 degrees Celsius regardless of combination of the above mentioned additive elements or their amount. Of course, a mother alloy of the purity of 99.999 wt % of Al is more preferable.

Using an aluminum alloy which consists of especially as additive element of the 10 - 300 wt ppm of Ni and the residual purity of more than 99.99 wt % of Al, stable and high bonding strength is realized at the low ultrasonic power.
When rolling to an ultra thin tape from a round wire, roll rolling is preferable to be done by one stage or two stages. The reason is that the phenomenon of unstable bonding strength was observed in the case of using an aluminum ribbon, which was rolled more than three stages of rolling. The Dispersion of this bonding strength at bonding is considered depending on what the consequence of rolled metallic structure is more pressed and then the internal strain of the metallic system becomes grater, and the portion of not-grown to coarse crystal grain by heat treatment after rolling is generated, and the crystal grain size becomes heterogeneous. Therefore, in the case of one stage roll rolling, the least dispersion of the bonding strength was attained.

### DESCRIPTION OF THE MOST PREFERRED EMBODIMENT

The most preferred embodiment of the present invention is explained hereinafter.
The composition of alloy shown in Table 2 and bonding wire with round diameter were used as starting materials, No. 1 - 20 Examples and No. 1 - 5 Controls shown in Table 2 were prepared. By the way, the purity of 99.999 wt % of Al was used as a conditioned material; in the case of using the purity of 99.99 wt % of Al also the same result was obtained. These bonding ribbons were roll rolled at one stage, and then they were heat treated at defined temperature shown in Table 2.

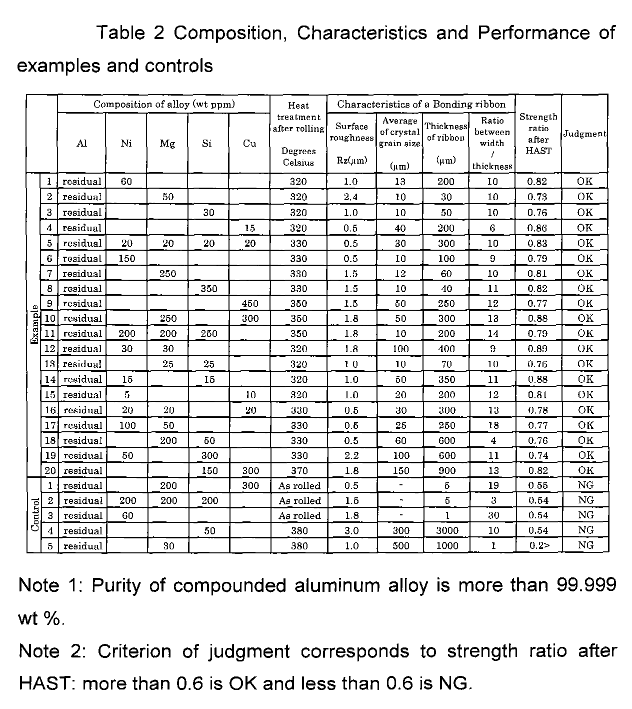

Examples 1 - 20 obtained from thus methods on the present invention and Controls 1 -5 were bonded to an aluminum plate (thickness is 5 mm) of purity of 99.99 wt % of Al by ultrasonic bonding, then bonding strength was investigated by HAST (Highly Accelerated Stress Test) for the following numbers and sizes. The judgment results are shown in Table 2.

The condition of ultrasonic bonding is as follows:
The length of a bonding ribbon shown in Table 2 is 10 mm, and the height of ribbon is 0.6 mm.
This ribbon was bonded to an aluminum plate (thickness is 5 mm),
which purity is 99.99 wt % of Al using a full automatic ribbon bonder Type 3600R from Orthodyne Electronics. As bonding condition,
frequency is 80 kHz; the compressed width was adjusted to be 1.2 times of the original width by the load and the ultrasonic conditions.
The space of pitch was 0.6 mm. The number of samples is 50 for each Example. The bonding tools and the bonding guides from Orthodyne Electronics were used corresponding to each size.
To the Examples which were heat-treated, the Controls as comparative examples were not heat-treated or heat-treated at 380 degrees Celsius.

The test condition of HAST (Highly Accelerated Stress Test) is as follows:
By the way, HAST is a standard of IEC68-2-66 as Environmental Test.
The Examples were left in the HAST equipment (Type PC-442R8D) from Hirayama Manufacturing Corporation at 85 degrees Celsius and moisture 85 % Rh for 96 hours. Evaluation criterion is the divided value of the bonding strength (gf) right after HAST by the bonding strength (gf) right after bonding (before HAST).

The Bondtester Type PC4000 from Dage Precision Industries Ltd. was used for shear strength evaluation. The height of shear test is 10 µm and the speed of shearing is 150 µm /sec. The average value of crystal grain size was calculated by the following manner.
An aluminum ribbon was molded into resin, and then a cross section of a ribbon was made by polishing, the crystal boundaries were revealed by chemical etching, a photograph was taken by Scanning Electron Microscopy (x 500), 3 straight lines were drawn along the direction of thickness of the ribbon on the photograph, counting the number of crystals along the line, the crystal grain size was calculated from divided value of the number of crystals by the thickness, then the average was calculated from 3 each values.

The aluminum ribbon of the Examples and the Controls were bonded by the similar mechanism to the conventional bonding mechanism of bonding wire aligned plural number of wires in the same pitch, and the contact surfaces to electrodes are similar to the bonding wires.
After a shear test, dissolving and peeling the aluminum ribbon, bonded sites of Example 1 - 20 were observed as a homogeneous bonded trace to a whole bonded surface. On the other hand, almost no bonded trace was observed in the case of Control 5. Moreover, bonded traces of Control 1- 4 were heterogeneous and insufficient.

## Claims

1. An aluminum ribbon for ultrasonic bonding comprising an aluminum alloy containing more than 99 wt % of Al, the aluminum alloy comprising additive elements and residual aluminum, wherein the aluminum ribbon has a tape structure formed by multi-stage cold rolling, the average crystal grain size at a cross section of the ribbon is 5 - 200 µm, the surface of the tape is mirror-finished and the surface roughness R_{z} is less than or equal to 2 µm.

2. An aluminum ribbon for ultrasonic bonding according to claim 1, wherein the additive elements comprise at least one element selected from Ni, Si, Mg and Cu, and the total amount of additive elements is 5 - 700 wt ppm.

3. An aluminum ribbon for ultrasonic bonding according to claim 1, comprising: Ni as an additive element in an amount of 10 - 300 wt ppm.

4. An aluminum ribbon for ultrasonic bonding according to claim 1, wherein the purity of the residual aluminum is more than 99.99 wt % and its impurity is less than 0.01 wt %.

5. An aluminum ribbon for ultrasonic bonding according to claim 1, wherein the purity of the residual aluminum is more than 99.999 wt % and its impurity is less than 0.001 wt %.
